# EUROPEAN PATENT APPLICATION

(11) **EP 3 278 976 A1**
(43) Date of publication of application: **07.02.2018**
(21) Application number: 16772494.7
(22) Date of filing: 23.03.2016
(51) Int. Cl.: B32B 7/02, B32B 27/00

(54) **GAS BARRIER LAMINATE, MEMBER FOR ELECTRONIC DEVICES, AND ELECTRONIC DEVICE**

(30) Priority: 30.03.2015 JP 2015069687
(71) Applicant: LINTEC Corporation, Tokyo 173-0001 (JP)
(72) Inventor: OHASHI, Takehiro, Tokyo 173-0001 (JP); IWAYA, Wataru, Tokyo 173-0001 (JP); SUZUKI, Yuta, Tokyo 173-0001 (JP)
(74) Representative: Beckmann, Claus
(86) International application number: PCT/JP2016/059209
(87) International publication number: WO 2016/158613

(57) **Abstract**

The present invention is: a gas barrier laminate comprising a base material and a gas barrier unit, wherein the gas barrier unit comprises a gas barrier layer (1) disposed on the base material side, and a gas barrier layer (2) disposed on a surface side of the gas barrier layer (1) opposite to the base material side, and a thickness of the gas barrier unit is 170 nm to 10 µm; an electronic device member comprising the gas barrier laminate; and an electronic device comprising the electronic device member. The present invention provides: a gas barrier laminate having excellent gas barrier properties and excellent colorlessness and transparency, an electronic device member comprising this gas barrier laminate, and an electronic device comprising this electronic device member.

## Description

### Technical Field

The present invention relates to a gas barrier laminate having excellent gas barrier properties and excellent colorlessness and transparency, an electronic device member comprising this gas barrier laminate, and an electronic device comprising this electronic device member.

### Background Art

In recent years, in a display such as a liquid crystal display or an electroluminescence (EL) display, as a substrate having an electrode, the so-called gas barrier film obtained by laminating a gas barrier layer on a transparent plastic film has been used instead of a glass plate in order to realize thinning, weight reduction, flexibility, and the like.

As the method for forming a gas barrier layer, a method of modifying a surface of a layer containing a polysilazane-based compound is known.

For example, in Patent Literature 1, a formed article having a layer obtained by implanting ions into a layer comprising a polysilazane-based compound is described. In this literature, it is also described that this layer obtained by implanting ions can function as a gas barrier layer.

### Citation List

### Patent Literature

Patent Literature 1: Japanese Patent Laid-Open No. 2012-117150 (US2012/064321)

### Summary of Invention

### Technical Problem

As described in Patent Literature 1, a gas barrier film having excellent gas barrier properties and transparency can be obtained by implanting ions into a layer comprising a polysilazane-based compound formed on a base material.

In addition, according to the study of the present inventors, it has been found that a gas barrier layer having better gas barrier properties can be formed by increasing the applied voltage when implanting ions.

However, a gas barrier film having such a gas barrier layer has tended to be yellowish.

The present invention has been made in view of the above circumstances, and it is an object of the present invention to provide a gas barrier laminate having excellent gas barrier properties and excellent colorlessness and transparency, an electronic device member comprising this gas barrier laminate, and an electronic device comprising this electronic device member.

### Solution to Problem

In order to solve the above problem, the present inventors have diligently studied a gas barrier laminate having a base material and a gas barrier layer. As a result, the present inventors have found that a gas barrier laminate having a base material and a gas barrier unit comprising a gas barrier layer (1) on the base material side and a gas barrier layer (2) provided on the gas barrier layer (1), provided on the base material directly or via another layer, wherein the thickness of the gas barrier unit is 170 nm to 10 µm, has excellent gas barrier properties and also excellent colorlessness and transparency, leading to the completion of the present invention.

Thus, according to the present invention, the gas barrier laminates of [1] to [5], the electronic device member of [6], and the electronic device of [7] described below are provided.
[1] A gas barrier laminate comprising a base material and a gas barrier unit, wherein the gas barrier unit comprises a gas barrier layer (1) disposed on the base material side, and a gas barrier layer (2) disposed on a surface side of the gas barrier layer (1) opposite to the base material side, and a thickness of the gas barrier unit is 170 nm to 10 µm.
[2] The gas barrier laminate according to [1], wherein a refractive index of the gas barrier layer (1) is 1.40 to 1.50, a refractive index of the gas barrier layer (2) is 1.50 to 1.75, and [optical film thickness of gas barrier layer (1)]/[optical film thickness of gas barrier layer (2)] is 3.0 or more.
[3] The gas barrier laminate according to [2], wherein a film density of the gas barrier layer (2) is 2.5 to 4.5 g/cm³.
[4] The gas barrier laminate according to [1], wherein the gas barrier layer (1) and the gas barrier layer (2) are formed using a material containing a polysilazane-based compound.
[5] The gas barrier laminate according to [4], wherein the gas barrier layer (2) is a portion modified by subjecting to modification treatment a surface of a layer containing a polysilazane-based compound provided on the base material directly or via another layer.
[6] An electronic device member comprising the gas barrier laminate according to any of the above [1] to [5].
[7] An electronic device comprising the electronic device member according to the above [6].

### Advantageous Effects of Invention

According to the present invention, a gas barrier laminate having excellent gas barrier properties and excellent colorlessness and transparency, an electronic device member comprising this gas barrier laminate, and an electronic device comprising this electronic device member are provided.

### Description of Embodiments

1) A gas barrier laminate and 2) an electronic device member and an electronic device according to the exemplary embodiments of the present invention are described in detail below.

### 1) Gas Barrier Laminate

The gas barrier laminate of the present invention comprises a base material and a gas barrier unit, and the gas barrier unit comprises a gas barrier layer (1) disposed on the base material side, and a gas barrier layer (2) disposed on the surface side of the gas barrier layer (1) opposite to the base material side, and the thickness of the gas barrier unit is 170 nm to 10 µm.

### (1) Base Material

The base material constituting the gas barrier laminate of the present invention is not particularly limited as long as it has excellent transparency and has sufficient strength as the base material of the gas barrier laminate.

As the base material, a resin film is usually used.

Examples of the resin component of the resin film include a polyimide, a polyamide, a polyamideimide, a polyphenylene ether, a polyetherketone, a polyetheretherketone, a polyolefin, a polyester, a polycarbonate, a polysulfone, a polyethersulfone, a polyphenylene sulfide, an acrylic resin, a cycloolefin-based polymer, and an aromatic polymer.

Among these, because of better transparency, and versatility, a polyester, a polyamide, or a cycloolefin-based polymer are preferred, and a polyester or a cycloolefin-based polymer is more preferred.

Examples of the polyester include polyethylene terephthalate, polybutylene terephthalate, polyethylene naphthalate, and a polyarylate. Polyethylene terephthalate is preferred.

Examples of the polyamide include a wholly aromatic polyamide, nylon 6, nylon 66, and a nylon copolymer.

Examples of the cycloolefin-based polymer include a norbornene-based polymer, a monocyclic olefin-based polymer, a cyclic conjugated diene-based polymer, a vinyl alicyclic hydrocarbon polymer, and a hydride thereof. Specific examples thereof include APEL (ethylene-cycloolefin copolymer manufactured by Mitsui Chemicals, Inc.), ARTON (norbornene-based polymer manufactured by JSR), and ZEONOR (norbornene-based polymer manufactured by ZEON Corporation).

The above resin film may contain various additives in a range that does not hinder the effect of the present invention. Examples of the additive include a UV absorber, an antistatic agent, a stabilizer, an antioxidant, a plasticizer, a lubricant, and a coloring pigment. The content of these additives should be appropriately determined according to the purpose.

The resin film can be obtained by preparing a resin composition comprising a resin component, and various additives as desired, and forming the resin composition into a film shape. The forming method is not particularly limited, and known methods such as a casting method and a melt extrusion method can be used.

The thickness of the base material is not particularly limited and should be determined according to the purpose of the gas barrier laminate. The thickness of the base material is usually 0.5 to 500 µm, preferably 1 to 100 µm.

The light transmittance of the base material at 380 to 780 nm is preferably 80% or more, more preferably 85% or more.

### (2) Gas Barrier Unit

The gas barrier unit constituting the gas barrier laminate of the present invention is provided on the base material directly or via another layer.

The gas barrier unit comprises the gas barrier layer (1) disposed on the base material side, and the gas barrier layer (2) disposed on the surface side of the gas barrier layer (1) opposite to the base material side.

The gas barrier unit may be obtained by disposing the gas barrier layer (1) and the gas barrier layer (2) adjacent to each other or may be obtained by disposing the gas barrier layer (1) and the gas barrier layer (2) with another layer (primer layer or the like) sandwiched therebetween.

The thickness of the gas barrier unit is 170 nm to 10 µm, preferably 170 to 500 nm, and more preferably 170 to 400 nm. When the thickness of the gas barrier unit is less than 170 nm, the colorlessness and transparency of the gas barrier laminate are likely to be poor. On the other hand, even if the thickness of the gas barrier unit is larger than 10 µm, an effect that matches it is difficult to obtain.

In the gas barrier unit, the value calculated by [optical film thickness of gas barrier layer (1)]/[optical film thickness of gas barrier layer (2)] is preferably 3.0 or more, more preferably 3.0 to 20.0, and still more preferably 3.0 to 10.0. When this value is 3.0 or more, a gas barrier laminate having better colorlessness and transparency is easily obtained.

The optical film thickness of the gas barrier layer is calculated by "refractive index of gas barrier layer × thickness of gas barrier layer".

The gas barrier layers (1) and (2) (the "gas barrier layers (1) and (2)" are hereinafter sometimes simply collectively referred to as the "gas barrier layers") are both layers having the property of suppressing the transmission of gases such as oxygen and water vapor (gas barrier properties).

In the present invention, no attention is paid to the gas barrier properties of the gas barrier layer alone, and therefore the gas barrier layer cannot be defined from the viewpoint of gas barrier performance. However, based on its refractive index, the gas barrier performance can be estimated. Usually, it can be said that a layer comprising a constituent component described later and having a refractive index of 1.40 or more has sufficient gas barrier properties.

The gas barrier layers (1) and (2) in the present invention can be distinguished by their constituent components and the values of physical properties such as refractive indices.

The gas barrier layer (1) is a layer disposed on the base material side in the gas barrier unit. The refractive index of the gas barrier layer (1) is preferably 1.40 to 1.50, more preferably 1.42 to 1.48. When the refractive index is within the above range, a gas barrier laminate having better colorlessness and transparency is easily obtained.

In the present invention, the refractive index refers to the refractive index of light having a wavelength of 590 nm measured at 23°C.

The thickness of the gas barrier layer (1) is not particularly limited but is preferably 169 nm to 5 µm, more preferably 169 to 300 nm.

The film density of the gas barrier layer (1) is preferably 1.0 to 2.5 g/cm³, more preferably 1.5 to 2.0 g/cm³.

When the film density of the gas barrier layer (1) is within the above range, a gas barrier laminate having better colorlessness and transparency and bendability is easily obtained.

The gas barrier layer (2) is a layer disposed on the surface side of the gas barrier layer (1) opposite to the base material side. The refractive index of the gas barrier layer (2) is preferably 1.50 to 1.75, more preferably 1.55 to 1.72. When the refractive index is within the above range, a gas barrier laminate having better colorlessness and transparency and bendability is easily obtained.

The thickness of the gas barrier layer (2) is not particularly limited but is preferably 1 nm to 5 µm, more preferably 1 to 200 nm, and particularly preferably 1 to 100 nm.

The film density of the gas barrier layer (2) is preferably 2.5 to 4.5 g/cm³, more preferably 2.7 to 4.0 g/cm³. When the film density of the gas barrier layer (2) is within the above range, a gas barrier laminate having better gas barrier properties and better colorlessness and transparency is easily obtained.

Examples of the constituent component of the gas barrier layers include an inorganic compound, a metal, and a polymeric compound.

Examples of the inorganic compound include inorganic oxides such as silicon oxide, aluminum oxide, magnesium oxide, zinc oxide, indium oxide, and tin oxide; inorganic nitrides such as silicon nitride; inorganic carbides such as silicon carbide; and composites thereof, inorganic oxynitrides, inorganic oxycarbides, inorganic carbonitrides, and inorganic oxycarbonitrides.

Examples of the metal include aluminum, magnesium, zinc, and tin.

Examples of the polymeric compound include a polymeric silicon compound.

Among these, it is preferred that the gas barrier layer (1) is a layer containing a polymeric silicon compound (hereinafter sometimes referred to as a "polymeric silicon compound layer"), and the gas barrier layer (2) is either a layer containing an inorganic compound or a layer containing a metal because a gas barrier laminate having better colorlessness and transparency and gas barrier properties is easily obtained.

Examples of the polymeric silicon compound constituting the polymeric silicon compound layer of the gas barrier layer (1) include a polysilazane-based compound, a polycarbosilane-based compound, a polysilane-based compound, and a polyorganosiloxane-based compound. Especially, the gas barrier layer (1) is preferably a layer containing a polysilazane-based compound (hereinafter sometimes referred to as a "polysilazane layer") because it has better gas barrier properties.

The details of a method for forming the polysilazane layer, and the like will be described later, and other polymeric silicon compound layers can be formed using similar methods.

Examples of the layer containing an inorganic compound or a metal, the gas barrier layer (2), include an inorganic vapor-deposited film and one obtained by subjecting the polymeric silicon compound layer to modification treatment [in this case, the gas barrier layer (2) means only the modified portion].

Examples of the inorganic vapor-deposited film include an inorganic compound and a metal vapor-deposited film.

Examples of the raw materials of the inorganic compound vapor-deposited film and the metal vapor-deposited film include those previously shown as the constituent components of the gas barrier layer. These may be used either alone or in combination.

Among these, an inorganic vapor-deposited film using an inorganic oxide, an inorganic nitride, or a metal as a raw material is preferred from the viewpoint of gas barrier properties, and further, an inorganic vapor-deposited film using an inorganic oxide or an inorganic nitride as a raw material is preferred from the viewpoint of transparency.

Examples of the method of forming the inorganic vapor-deposited film include PVD (physical vapor deposition) methods such as a vacuum vapor deposition method, a sputtering method, and an ion plating method, and CVD methods such as a thermal CVD (chemical vapor deposition) method, a plasma CVD method, and a photo-CVD method.

As the layer obtained by subjecting the polymeric silicon compound layer to modification treatment, one obtained by subjecting a polysilazane layer to modification treatment is preferred. The details of the method for modifying the polysilazane layer, and the like will be described later, and when other polymeric silicon compound layers are modified, similar methods can be used.

The gas barrier layer (1) and the gas barrier layer (2) (that is, the gas barrier unit) can be efficiently formed by using a material containing a polysilazane-based compound. Specifically, the desired gas barrier unit can be efficiently formed by forming a polysilazane layer on a base material directly or via another layer and subjecting the surface of the formed polysilazane layer to modification treatment. At this time, the gas barrier layer (1) is the unmodified portion, and the gas barrier layer (2) is the modified portion.

The polysilazane-based compound is a polymeric compound having a repeating unit containing a -Si-N- bond (silazane bond) in the molecule. Specifically, a compound having a repeating unit represented by formula (1) :

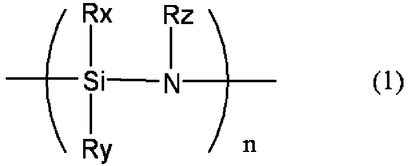

is preferred. The number average molecular weight of the polysilazane-based compound used is not particularly limited but is preferably 100 to 50,000.

In the formula (1), n represents any natural number. Rx, Ry, and Rz each independently represent a hydrogen atom or a non-hydrolyzable group such as an unsubstituted or substituted alkyl group, an unsubstituted or substituted cycloalkyl group, an unsubstituted or substituted alkenyl group, an unsubstituted or substituted aryl group, or an alkylsilyl group.

Examples of the alkyl group of the unsubstituted or substituted alkyl group include alkyl groups having 1 to 10 carbon atoms such as a methyl group, an ethyl group, a n-propyl group, an isopropyl group, a n-butyl group, an isobutyl group, a sec-butyl group, a t-butyl group, a n-pentyl group, an isopentyl group, a neopentyl group, a n-hexyl group, a n-heptyl group, and a n-octyl group.

Examples of the cycloalkyl group of the unsubstituted or substituted cycloalkyl group include cycloalkyl groups having 3 to 10 carbon atoms such as a cyclobutyl group, a cyclopentyl group, a cyclohexyl group, and a cycloheptyl group.

Examples of the alkenyl group of the unsubstituted or substituted alkenyl group include alkenyl groups having 2 to 10 carbon atoms such as a vinyl group, a 1-propenyl group, a 2-propenyl group, a 1-butenyl group, a 2-butenyl group, and a 3-butenyl group.

Examples of the substituents of the alkyl group, cycloalkyl group, and alkenyl group include halogen atoms such as a fluorine atom, a chlorine atom, a bromine atom, and an iodine atom; a hydroxyl group; a thiol group; an epoxy group; a glycidoxy group; a (meth)acryloyloxy group; and unsubstituted or substituted aryl groups such as a phenyl group, a 4-methylphenyl group, and a 4-chlorophenyl group.

Examples of the aryl group of the unsubstituted or substituted aryl group include aryl groups having 6 to 10 carbon atoms such as a phenyl group, a 1-naphthyl group, and a 2-naphthyl group.

Examples of the substituent of the aryl group include halogen atoms such as a fluorine atom, a chlorine atom, a bromine atom, and an iodine atom; alkyl groups having 1 to 6 carbon atoms such as a methyl group and an ethyl group; alkoxy groups having 1 to 6 carbon atoms such as a methoxy group and an ethoxy group; a nitro group; a cyano group; a hydroxyl group; a thiol group; an epoxy group; a glycidoxy group; a (meth)acryloyloxy group; and unsubstituted or substituted aryl groups such as a phenyl group, a 4-methylphenyl group, and a 4-chlorophenyl group.

Examples of the alkylsilyl group include a trimethylsilyl group, a triethylsilyl group, a triisopropylsilyl group, a tri-t-butylsilyl group, a methyldiethylsilyl group, a dimethylsilyl group, a diethylsilyl group, a methylsilyl group, and an ethylsilyl group.

Among these, as Rx, Ry, and Rz, a hydrogen atom, alkyl groups having 1 to 6 carbon atoms, or a phenyl group is preferred, and a hydrogen atom is particularly preferred.

The polysilazane-based compound having the repeating unit represented by the formula (1) may be either an inorganic polysilazane in which Rx, Ry, and Rz are all hydrogen atoms or an organic polysilazane in which at least one of Rx, Ry, and Rz is not a hydrogen atom.

In the present invention, as the polysilazane-based compound, a polysilazane modified product can also be used. Examples of the polysilazane modified product include those described in Japanese Patent Laid-Open No. 62-195024, Japanese Patent Laid-Open No. 2-84437, Japanese Patent Laid-Open No. 63-81122, Japanese Patent Laid-Open No. 1-138108, Japanese Patent Laid-Open No. 2-175726, Japanese Patent Laid-Open No. 5-238827, Japanese Patent Laid-Open No. 5-238827, Japanese Patent Laid-Open No. 6-122852, Japanese Patent Laid-Open No. 6-306329, Japanese Patent Laid-Open No. 6-299118, Japanese Patent Laid-Open No. 9-31333, Japanese Patent Laid-Open No. 5-345826, Japanese Patent Laid-Open No. 4-63833, and the like.

Among these, as the polysilazane-based compound, perhydropolysilazane in which Rx, Ry, and Rz are all hydrogen atoms is preferred from the viewpoint of easy availability and being able to form an ion-implanted layer having excellent gas barrier properties.

As the polysilazane-based compound, a commercial product commercially available as a glass coating material or the like can also be used as it is.

Polysilazane-based compounds may be used either alone or in combination.

The polysilazane layer may contain other components in addition to the above-described polysilazane-based compound in a range that does not inhibit the object of the present invention. Examples of the other components include a curing agent, an anti-aging agent, a light stabilizer, and a flame retardant.

The content of the polysilazane-based compound in the polysilazane layer is preferably 50% by mass or more, more preferably 70% by mass or more, because a gas barrier layer having better gas barrier properties is obtained.

The thickness of the polysilazane layer is not particularly limited but is usually 170 nm to 10 µm, preferably 170 to 500 nm, and more preferably 170 to 400 nm.

In the present invention, even if the polysilazane layer is of the nano-order, a gas barrier laminate having sufficient gas barrier properties can be obtained.

The method of forming the polysilazane layer is not particularly limited. For example, the polysilazane layer can be formed by preparing a polysilazane layer-forming solution containing at least one polysilazane-based compound, other components as desired, a solvent, and the like, then applying this polysilazane layer-forming solution by a known method, and drying the obtained coating.

Examples of the solvent used in the polysilazane layer-forming solution include aromatic hydrocarbon-based solvents such as benzene and toluene; ester-based solvents such as ethyl acetate and butyl acetate; ketone-based solvents such as acetone, methyl ethyl ketone, and methyl isobutyl ketone; aliphatic hydrocarbon-based solvents such as n-pentane, n-hexane, and n-heptane; and alicyclic hydrocarbon-based solvents such as cyclopentane and cyclohexane.

These solvents may be used either alone or in combination.

Examples of the method for applying the polysilazane layer-forming solution include a bar coating method, a spin coating method, a dipping method, a roll coating method, a gravure coating method, a knife coating method, an air knife coating method, a roll knife coating method, a die coating method, a screen printing method, a spray coating method, and a gravure offset method.

As the method of drying the formed coating, conventionally known drying methods such as hot air drying, hot roll drying, and infrared irradiation can be adopted. The heating temperature is usually in the range of 60 to 130°C. The heating time is usually several seconds to several tens of minutes.

Examples of the modification treatment of the polysilazane layer include ion implantation treatment, plasma treatment, ultraviolet irradiation treatment, and heat treatment.

The ion implantation treatment is a method of implanting ions into the polysilazane layer to modify the polysilazane layer as described later.

The plasma treatment is a method of exposing the polysilazane layer to plasma to modify the polysilazane layer. For example, plasma treatment can be performed according to a method described in Japanese Patent Laid-Open No. 2012-106421.

The ultraviolet irradiation treatment is a method of irradiating the polysilazane layer with ultraviolet rays to modify the polysilazane layer. For example, ultraviolet modification treatment can be performed according to a method described in Japanese Patent Laid-Open No. 2013-226757.

Among these, ion implantation treatment is preferred because the polysilazane layer can be efficiently modified to its inside without roughening the surface of the polysilazane layer, to form the gas barrier layer (2) having better gas barrier properties.

Examples of the ion implanted into the polysilazane layer include ions of rare gases such as argon, helium, neon, krypton, and xenon; ions of fluorocarbon, hydrogen, nitrogen, oxygen, carbon dioxide, chlorine, fluorine, sulfur, and the like; ions of alkane-based gases such as methane and ethane; ions of alkene-based gases such as ethylene and propylene; ions of alkadiene-based gases such as pentadiene and butadiene; ions of alkyne-based gases such as acetylene; ions of aromatic hydrocarbon-based gases such as benzene and toluene; ions of cycloalkane-based gases such as cyclopropane; ions of cycloalkene-based gases such as cyclopentene; ions of metals; and ions of organosilicon compounds.

These ions may be used either alone or in combination.

Among these, ions of rare gases such as argon, helium, neon, krypton, and xenon are preferred because ions can be more simply implanted, and the gas barrier layer (2) having better gas barrier properties can be formed.

The amount of ions implanted can be appropriately determined according to the purpose of use of the gas barrier laminate (necessary gas barrier properties, transparency, and the like), and the like.

Examples of the method of implanting ions include a method of radiating ions accelerated by an electric field (ion beam), and a method of implanting ions in plasma. Especially, the latter method of implanting plasma ions is preferred because the desired gas barrier layer (2) can be simply formed.

The plasma ion implantation can be performed, for example, by generating plasma under an atmosphere comprising a plasma-producing gas such as a rare gas, and applying negative high voltage pulses to the polysilazane layer to implant ions (cations) in the plasma into the surface area of the polysilazane layer.

The plasma ion implantation can be performed using a known plasma ion implantation apparatus.

The pressure when ions are implanted (pressure during plasma ion implantation) is usually 0.01 to 5 Pa, preferably 0.01 to 1 Pa. When the pressure during plasma ion implantation is in such a range, a uniform ion-implanted layer can be simply and efficiently formed, and the gas barrier layer (2) having both transparency and gas barrier properties can be efficiently formed.

The pulse width when negative high voltage pulses are applied, that is, when ions are implanted, is preferably 1 to 15 µsec. When the pulse width is in such a range, the gas barrier layer (2) that is transparent and uniform can be more simply and efficiently formed. The negative pulsed high voltage for applying a negative high voltage to the polysilazane layer is -100 kV to -100 V, preferably -50 kV to -1 kV. When the pulsed high voltage is in such a range, the gas barrier layer (2) that is transparent and uniform can be more simply and efficiently formed.

The applied voltage when plasma is generated is preferably -1 kV to -50 kV, more preferably -1 kV to -30 kV, and particularly preferably -5 kV to -20 kV. When ion implantation is performed with the applied voltage being a value greater than -1 kV, the amount of ions implanted (dose) is insufficient, and the desired performance may not be obtained. On the other hand, when ion implantation is performed with the applied voltage being a value less than -50 kV, the laminate is charged during ion implantation, and problems such as the coloration of the laminate occur, which are not preferred.

The thickness of the region into which ions are implanted by ion implantation can be controlled by implantation conditions such as the type of ions, the applied voltage, and the treatment time and should be determined according to the thickness of the polysilazane layer, the purpose of use of the laminate, and the like but is usually 10 to 1000 nm, preferably 10 to 400 nm.

### (3) Gas Barrier Laminate

The gas barrier laminate of the present invention has the base material and the gas barrier unit provided on this base material directly or via another layer.

The gas barrier laminate of the present invention may have a layer other than the base material and the gas barrier unit.

Examples of the layer other than the base material and the gas barrier unit include a primer layer, an electrical conductor layer, an impact-absorbing layer, a pressure-sensitive adhesive layer, a hard coat layer, and a process sheet. The process sheet has the role of protecting the gas barrier laminate when storing and transporting the gas barrier laminate, and the like and is peeled off when the gas barrier laminate is used.

Examples of the layer configuration of the gas barrier laminate of the present invention include, but are not limited to, the following. In these layer configurations, the gas barrier unit is represented as "gas barrier layer (1)/gas barrier layer (2)".
(i) base material/gas barrier layer (1)/gas barrier layer (2)
(ii) hard coat layer/base material/gas barrier layer (1)/gas barrier layer (2)
(iii) base material/primer layer/gas barrier layer (1)/gas barrier layer (2)
(iv) hard coat layer/base material/primer layer/gas barrier layer (1)/gas barrier layer (2)

The thickness of the gas barrier laminate of the present invention is not particularly limited but is preferably 1 to 1000 µm, more preferably 10 to 500 µm, and still more preferably 40 to 100 µm.

The water vapor transmission rate of the gas barrier laminate of the present invention at a temperature of 40°C and a relative humidity of 90% is preferably 0.100 g/(m²·day) or less, more preferably 0.050 g/(m²·day) or less, and still more preferably 0.030 g/(m²·day) or less. There is no particular lower limit value, and the water vapor transmission rate is preferably lower but is usually 0.001 g/(m²·day) or more.

The water vapor transmission rate can be measured by a method described in Examples.

The b* value in the CIE L*a*b* color system defined in JIS Z 8729-1994 for the gas barrier laminate of the present invention is preferably -1.0 to 1.0, more preferably -0.8 to 0.8.

The b* value represents the degree of yellowness and blueness when color is digitized. When the b* value is a positive value, it represents yellowishness, and when the b* value is a negative value, it represents bluishness.

When the b* value is in the above range, the gas barrier laminate assumes a hue more intermediate between yellow and blue.

The b* value can be efficiently kept within the range of -1.0 to 1.0 by changing the thickness of the gas barrier unit or the optical film thicknesses of the gas barrier layers, or the like.

In this manner, the gas barrier laminate of the present invention has excellent gas barrier properties and excellent colorlessness and transparency, and therefore is preferably used as an electronic device member.

### 2) Electronic Device Member and Electronic Device

The electronic device member of the present invention comprises the gas barrier laminate of the present invention. Therefore, the electronic device member of the present invention has excellent gas barrier properties, and therefore the deterioration of an element due to gases such as water vapor can be prevented. In addition, the electronic device member of the present invention has excellent colorlessness and transparency and therefore is preferred as a display member for a liquid crystal display, an EL display, or the like; or the like.

The electronic device of the present invention comprises the electronic device member of the present invention. Specific examples include a liquid crystal display, an organic EL display, an inorganic EL display, electronic paper, and a solar battery.

The electronic device of the present invention comprises an electronic device member comprising the gas barrier laminate of the present invention and therefore has excellent gas barrier properties.

### Examples

The present invention will be described in more detail below by giving Examples. However, the present invention is not limited to the following examples in any way.

In examples, the units "parts" and "%" respectively refer to "parts by weight" and "wt%" unless otherwise indicated.

### [Measurement of b* Value]

The b* value in the L*a*b* color system for each of gas barrier films obtained in Examples 1 to 6 and Comparative Examples 1 and 2 was measured using "UV-3600" manufactured by Shimadzu Corporation. The b* value is an indicator in the color coordinates defined in JISZ8729.

### [Measurement of Water Vapor Transmission Rate]

The water vapor transmission rate of each of the gas barrier films obtained in Examples 1 to 6 and Comparative Examples 1 and 2 was measured using "AQUATRAN-1" manufactured by MOCON Inc. The measurement was performed under an atmosphere of 40°C and a relative humidity of 90%.

### [Measurement of Refractive Indices and Film Thicknesses]

For each of the gas barrier films obtained in Examples 1 to 6 and Comparative Examples 1 and 2, the refractive indices and film thicknesses of the gas barrier layer (1) and the gas barrier layer (2) were measured using "spectroscopic ellipsometry 2000U" manufactured by J.A. Woollam Japan Corp. The measurement was performed at 23°C using light having a wavelength of 590 nm.

### [Measurement of Film Density]

The reflectance of X-rays was measured under the measurement conditions shown below using a thin film evaluation sample horizontal type X-ray diffraction apparatus ("SmartLab" manufactured by Rigaku Corporation) to obtain the total reflection critical angle θc, and from the value, the film density of the gas barrier layer (2) was calculated.

### (Measurement Conditions)

X-ray source: Cu-Kα1 (wavelength: 1.54059 Å)
Optical system: parallel beam optical system
Entrance side slit system: two crystals of Ge(220), height limiting slit 5 mm, entrance slit 0.05 mm
Receiving side slit system: receiving slit 0.10 mm, solar slit 5°
Detector: scintillation counter
Tube voltage·tube current: 45 kV-200 mA
Scan axis: 2θ/θ
Scan mode: continuous scan
Scan range: 0.1-3.0 deg.
Scan speed: 1 deg./min.
Sampling interval: 0.002°/step

For the atomic ratio, the abundances of oxygen atoms, nitrogen atoms, and silicon atoms in the surface layer part of the gas barrier layer obtained by X-ray photoelectron spectroscopy measurement were used.

### [Example 1]

Perhydropolysilazane ("NL-110" manufactured by AZ Electronic Materials) was applied to the non-easily-contactable surface of a polyethylene terephthalate (PET) film having a thickness of 50 µm ("COSMOSHINE A-4100" manufactured by Toyobo Co., Ltd.) and heated and cured at 120°C for 2 minutes to form a polysilazane layer. The film thickness of the polysilazane layer was 200 nm.

Then, the above polysilazane layer was subjected to plasma ion implantation under the following conditions using a plasma ion implantation apparatus, to modify the surface of the polysilazane layer to obtain a gas barrier film (a gas barrier laminate having a base material and a gas barrier unit directly provided on the base material). For this gas barrier film, various measurements were performed. The measurement results are shown in Table 1.

### [Plasma Ion Implantation Treatment Conditions]

Chamber internal pressure: 0.2 Pa
Plasma-producing gas: argon
Gas flow rate: 100 sccm
RF output: 1000 W
RF frequency: 1000 Hz
RF pulse width: 50 µsec
RF delay: 25 nsec
DC voltage: -6 kV
DC frequency: 1000 Hz
DC pulse width: 5 µsec
DC delay: 50 µsec
Duty ratio: 0.5%
Treatment time: 200 sec

### [Example 2]

A gas barrier film was obtained in the same manner as in Example 1 except that in Example 1, the film thickness of the polysilazane layer was changed to 250 nm. Various measurements were performed. The measurement results are shown in Table 1.

### [Example 3]

A gas barrier film was obtained in the same manner as in Example 1 except that in Example 1, the film thickness of the polysilazane layer was changed to 200 nm, and the DC voltage was changed to -10 kV. Various measurements were performed. The measurement results are shown in Table 1.

### [Example 4]

A gas barrier film was obtained in the same manner as in Example 1 except that in Example 1, the film thickness of the polysilazane layer was changed to 250 nm, and the DC voltage was changed to -10 kV. Various measurements were performed. The measurement results are shown in Table 1.

### [Example 5]

A gas barrier film was obtained in the same manner as in Example 1 except that in Example 1, the film thickness of the polysilazane layer was changed to 200 nm, and the DC voltage was changed to -15 kV. Various measurements were performed. The measurement results are shown in Table 1.

### [Example 6]

A gas barrier film was obtained in the same manner as in Example 1 except that in Example 1, the film thickness of the polysilazane layer was changed to 250 nm, and the DC voltage was changed to -15 kV. Various measurements were performed. The measurement results are shown in Table 1.

### [Comparative Example 1]

A gas barrier film was obtained in the same manner as in Example 1 except that in Example 1, the film thickness of the polysilazane layer was changed to 130 nm, and the DC voltage was changed to -10 kV. Various measurements were performed. The measurement results are shown in Table 1.

### [Comparative Example 2]

A gas barrier film was obtained in the same manner as in Comparative Example 1 except that in Comparative Example 1, the DC voltage was changed to -15 kV. Various measurements were performed. The measurement results are shown in Table 1.

**Table 1**

| | | Examples | | | | | | Comparative Examples | |
|---|---|---|---|---|---|---|---|---|---|
| | | 1 | 2 | 3 | 4 | 5 | 6 | 1 | 2 |
| Applied voltage (kV) | | -6 | -6 | -10 | -10 | -15 | -15 | -10 | -15 |
| Thickness of gas barrier unit (nm) | | 200 | 250 | 200 | 250 | 200 | 250 | 130 | 130 |
| Optical film thickness ratio | | 7.6 | 9.4 | 4.4 | 5.5 | 3.4 | 4.5 | 2.9 | 1.9 |
| Gas barrier layer (1) | Film thickness (nm) | 180 | 230 | 170 | 220 | 160 | 210 | 100 | 90 |
| | Refractive index | 1.47 | 1.48 | 1.45 | 1.46 | 1.46 | 1.47 | 1.46 | 1.47 |
| | Optical film thickness (nm) | 264.6 | 340.4 | 246.5 | 321.2 | 233.6 | 308.7 | 146.0 | 132.3 |
| Gas barrier layer (2) | Film thickness (nm) | 20 | 20 | 30 | 30 | 40 | 40 | 30 | 40 |
| | Refractive index | 1.58 | 1.57 | 1.68 | 1.66 | 1.72 | 1.70 | 1.65 | 1.73 |
| | Optical film thickness (nm) | 31.6 | 31.4 | 50.4 | 49.8 | 68.8 | 68.0 | 49.5 | 69.2 |
| | Film density (g/cm³) | 2.7 | 2.5 | 3.2 | 3.4 | 3.8 | 3.7 | 3.0 | 3.7 |
| b^{*} value | | 0.2 | 0.2 | 0.7 | 0.8 | 0.9 | 0.9 | 1.9 | 2.1 |
| Water vapor transmission rate (g/m²· day) | | 0.020 | 0.020 | 0.007 | 0.007 | 0.003 | 0.003 | 0.007 | 0.003 |

The optical film thickness ratio represents [optical film thickness of gas barrier layer (1)]/[optical film thickness of gas barrier layer (2)].

From Table 1, the following are found.

In the gas barrier films obtained in Examples 1 to 6, the thickness of the gas barrier unit is 170 nm or more, and the gas barrier films are not yellowish. When these gas barrier films are compared, it is found that as the value of the applied voltage increases, the gas barrier properties improve.

On the other hand, in the gas barrier films obtained in Comparative Examples 1 and 2, the thickness of the gas barrier unit is less than 170 nm, and the b* value exceeds 1.0.

## Claims

1. A gas barrier laminate comprising a base material and a gas barrier unit, wherein
the gas barrier unit comprises a gas barrier layer (1) disposed on the base material side, and a gas barrier layer (2) disposed on a surface side of the gas barrier layer (1) opposite to the base material side, and
a thickness of the gas barrier unit is 170 nm to 10 µm.

2. The gas barrier laminate according to claim 1, wherein a refractive index of the gas barrier layer (1) is 1.40 to 1.50, a refractive index of the gas barrier layer (2) is 1.50 to 1.75, and [optical film thickness of gas barrier layer (1)]/[optical film thickness of gas barrier layer (2)] is 3.0 or more.

3. The gas barrier laminate according to claim 2, wherein a film density of the gas barrier layer (2) is 2.5 to 4.5 g/cm³.

4. The gas barrier laminate according to claim 1, wherein the gas barrier layer (1) and the gas barrier layer (2) are formed using a material containing a polysilazane-based compound.

5. The gas barrier laminate according to claim 4, wherein the gas barrier layer (2) is a portion modified by subjecting to modification treatment a surface of a layer containing a polysilazane-based compound provided on the base material directly or via another layer.

6. An electronic device member comprising the gas barrier laminate according to any one of claims 1 to 5.

7. An electronic device comprising the electronic device member according to claim 6.
